# EUROPEAN PATENT APPLICATION

(11) **EP 3 783 797 A1**
(43) Date of publication of application: **24.02.2021**
(21) Application number: 19789141.9
(22) Date of filing: 03.04.2019
(51) Int. Cl.: H02S 50/10, H01L 31/054

(54) **PRESSURE TEST METHOD FOR SOLAR POWER GENERATION DEVICE HOUSING UNIT**

(30) Priority: 18.04.2018 JP 2018079652
(71) Applicant: SUMITOMO ELECTRIC INDUSTRIES, LTD., Osaka-shi, Osaka 541-0041 (JP)
(72) Inventor: KOIKE, Yukio, Osaka-shi, Osaka 541-0041 (JP); SAITO, Kenji, Osaka-shi, Osaka 541-0041 (JP); IMAI, Ryusuke, Osaka-shi, Osaka 541-0041 (JP)
(74) Representative: Boult Wade Tennant LLP
(86) International application number: PCT/JP2019/014723
(87) International publication number: WO 2019/202978

(57) **Abstract**

A housing unit including a first opening, an internal space in communication with the first opening, a through hole that allows communication from the outside to the internal space, and a porous membrane that covers the first through hole is prepared. A pressure in the internal space is measured while the first porous membrane covers the first through hole and the first opening in the housing unit is closed.

## Description

### TECHNICAL FIELD

The present disclosure relates to a method of checking a pressure in a housing unit for a photovoltaic power generation apparatus. The present application claims priority to Japanese Patent Application No. 2018-079652 filed on April 18, 2018, the entire contents of which are herein incorporated by reference.

### BACKGROUND ART

A photovoltaic power generation apparatus that concentrates solar rays and converts solar rays into electric power has conventionally been developed. For example, Japanese Patent Laying-Open No. 2017-73853 (PTL 1) discloses such a concentrator photovoltaic power generation apparatus.

This concentrator photovoltaic power generation apparatus includes a plurality of photovoltaic power generation modules. Each photovoltaic power generation module mainly includes a housing, a power generation element arranged in the housing, and a lens member that concentrates solar rays to the power generation element.

Such a concentrator photovoltaic power generation apparatus is installed outdoors for necessity of concentration of solar rays, and exposed to wind and rain. When rainwater enters the housing, moisture adheres to a power generation element or wiring, which leads to a problem of corrosion of wires or decrease in amount of power generation. Therefore, it is important to confirm absence of a gap or a hole through which rainwater enters the housing.

For example, Japanese Patent Laying-Open No. 2001-205056 (PTL 2) discloses a method of checking for leakage. In PTL 2, whether or not there is leakage through a separation membrane is examined by immersing the separation membrane into an aqueous solution of an organic solvent and thereafter applying a pressure thereto from a secondary side.

### CITATION LIST

### PATENT LITERATURE

PTL 1: Japanese Patent Laying-Open No. 2017-73853
PTL 2: Japanese Patent Laying-Open No. 2001-205056

### SUMMARY OF INVENTION

A method of checking a pressure in a housing unit for a photovoltaic power generation apparatus according to one manner of the present disclosure includes a step below.

A housing unit including a first opening, an internal space in communication with the first opening, a first through hole that allows communication from the outside to the internal space, and a first porous membrane that covers the first through hole and includes pores that allow communication from the outside to the internal space is prepared. A pressure in the internal space is measured while the first porous membrane covers the first through hole and the first opening in the housing unit is closed.

### BRIEF DESCRIPTION OF DRAWINGS

Fig. 1 is a perspective view showing a construction of a concentrator photovoltaic power generation apparatus according to one embodiment.
Fig. 2 is an exploded perspective view showing a construction of a photovoltaic power generation module included in the concentrator photovoltaic power generation apparatus shown in Fig. 1.
Fig. 3 is an assembly cross-sectional view showing the construction of the photovoltaic power generation module shown in Fig. 2.
Fig. 4 is a plan view showing a construction of a housing unit in which a lens member has been removed from the photovoltaic power generation module shown in Fig. 3.
Fig. 5 is a cross-sectional view showing a state before measurement of an internal pressure in the housing unit for the photovoltaic power generation apparatus according to one embodiment.
Fig. 6 is a diagram for illustrating a sealing gasket including a closed-cell structure.
Fig. 7 is a flowchart showing a method of checking a pressure in the housing unit for the photovoltaic power generation apparatus according to one embodiment.
Fig. 8 is a cross-sectional view showing a state of measurement of an internal pressure in the housing unit for the photovoltaic power generation apparatus according to one embodiment.
Fig. 9 is a diagram showing leakage characteristics after reduction in pressure in an internal space in the housing unit for the photovoltaic power generation apparatus according to one embodiment.
Fig. 10 is a diagram showing leakage characteristics after increase in pressure in the internal space in the housing unit for the photovoltaic power generation apparatus according to Comparative Example.
Fig. 11 is a diagram showing relation between a pressure in the internal space and an amount of warpage of the housing unit during pressure reduction in the internal space in the housing unit for the photovoltaic power generation apparatus according to one embodiment.
Fig. 12 is a diagram for illustrating an amount of warpage of the housing unit.

### DETAILED DESCRIPTION

### [Problem to be Solved by the Present Disclosure]

A gap or a hole through which rainwater enters the housing may be checked for by adopting a method as described in PTL 2 and immersing the housing into liquid.

In this case, however, the housing should be immersed into liquid and the wet housing should be dried. Therefore, man-hours additionally increase and a manufacturing lead time increases. Furthermore, in mass production of relatively large products for a concentrator photovoltaic power generation apparatus, a large space for drying is required. Therefore, it is difficult to incorporate this inspection step into a line for manufacturing photovoltaic power generation modules, and inspection inevitably has to be done off-line.

An object of one manner of the present disclosure is to provide a method of checking a pressure in a housing unit for a photovoltaic power generation apparatus that does not require drying of a wet housing, is less in time and efforts for 100% inspection, and allows easy incorporation of an inspection step into a line for manufacturing photovoltaic power generation modules.

### [Advantageous Effect of the Present Disclosure]

According to the present disclosure, a method of checking a pressure in a housing unit for a photovoltaic power generation apparatus that does not require drying of a wet housing, is less in time and efforts for 100% inspection, and allows easy incorporation of an inspection step into a line for manufacturing photovoltaic power generation modules can be realized.

### [Description of Embodiments of the Present Disclosure]

Embodiments of the present invention will initially be listed and described.

(1) A method of checking a pressure in a housing unit for a photovoltaic power generation apparatus according to one manner of the present disclosure includes a step below.

A housing unit including a first opening, an internal space in communication with the first opening, a first through hole that allows communication from the outside to the internal space, and a first porous membrane that covers the first through hole and includes pores that allow communication from the outside to the internal space is prepared. A pressure in the internal space is measured while the first porous membrane covers the first through hole and the first opening in the housing unit is closed.

A pressure in the internal space in the housing unit can thus be measured without immersing the housing unit in liquid. Therefore, time and trouble and a large space for drying wet housing units are not required. Incorporation (in-line) of this pressure checking process into a line for manufacturing photovoltaic power generation modules is facilitated and checking can be done in a simplified manner in a short period of time. Time and trouble and efforts for 100% inspection are also less.

By measuring a pressure, a gap or a hole in the housing unit other than pores in the porous membrane that allows communication from the outside to the internal space can be checked for. Whether or not there is a gap or a hole through which rainwater enters the housing unit in arrangement of the photovoltaic power generation module outdoors can thus be determined.

Since determination above is made based on a pressure value or a rate of variation in pressure, accuracy in checking can be high also for a housing unit in which an internal space communicates with the outside through the first porous membrane.

(2) In the method of checking a pressure in a housing unit for a photovoltaic power generation apparatus in (1), in the preparing a housing unit, the housing unit is prepared to include a housing, a bottom plate, a flexible printed circuit board, and a shield plate. The housing surrounds the internal space and includes the first opening at a first end and a second opening at a second end opposed to the first end. The bottom plate is attached to the housing to close the second opening. The flexible printed circuit board is attached to the bottom plate to be located in the internal space, and a power generation element is mounted on the flexible printed circuit board. The shield plate is located above the flexible printed circuit board and includes a light transmission window directly above the power generation element.

By checking a pressure in such a state, a gap or a hole that may permit entry of rainwater at a portion where the first porous membrane is attached to the housing and a portion where the bottom plate is attached to the housing can be checked for.

(3) In the method of checking a pressure in a housing unit for a photovoltaic power generation apparatus in (2), in the preparing a housing unit, the housing is prepared to include a peripheral wall portion that includes the first opening at the first end and the second opening at the second end and an intermediate bar attached to the peripheral wall portion to separate the second opening into two openings. In the measuring a pressure in the internal space, a pressure in the internal space is measured with a pressure sensor arranged directly above the intermediate bar.

By thus providing a pressure sensor at a position directly above the intermediate bar, checking can be done on both sides of the intermediate bar with the same accuracy without any imbalance.

(4) In the method of checking a pressure in a housing unit for a photovoltaic power generation apparatus in (2), in the preparing a housing unit, the housing unit is prepared to include a second through hole that is arranged such that the second opening lies between the second through hole and the first through hole and allows communication from the outside to the internal space and a second porous membrane that covers the second through hole. In the measuring a pressure in the internal space, a pressure in the internal space is measured with a pressure sensor arranged at a position intermediate between the first through hole and the second through hole in a plan view.

By thus providing a pressure sensor at a position intermediate between the first through hole and the second through hole, the pressure sensor is located equidistantly from the first through hole and the second through hole and checking can be done on both sides with the same accuracy without any imbalance.

(5) The method of checking a pressure in a housing unit for a photovoltaic power generation apparatus in (2) further includes reducing a pressure in the internal space in the housing unit before the measuring a pressure in the internal space.

By thus measuring a pressure in the internal space after pressure reduction in the internal space in the housing unit, checking can be done with accuracy higher than in measurement of a pressure after increase in pressure in the internal space. A load test of a photovoltaic power generation module is conducted by applying a load onto a rear surface of the bottom plate to warp the bottom plate toward the inside of the module. By reducing a pressure in the internal space, a pseudo load test of the module can also be conducted.

(6) In the method of checking a pressure in a housing unit for a photovoltaic power generation apparatus in (5), the pressure in the internal space in the housing unit is reduced to a pressure not lower than -2500 Pa and not higher than -800 Pa.

When a pressure in the internal space in the housing unit is higher than -800 Pa (a negative pressure is weaker), a pressure difference between a non-defective product and a defective product is too small and accuracy in checking is poor. When a pressure in the internal space in the housing unit is lower than -2500 Pa (a negative pressure is stronger), the bottom plate may deform and the photovoltaic power generation module may be damaged.

(7) In the method of checking a pressure in a housing unit for a photovoltaic power generation apparatus in (5), in the preparing a housing unit, the housing is prepared to include a peripheral wall portion that includes the first opening at the first end and the second opening at the second end and an intermediate bar attached to the peripheral wall portion to separate the second opening into two openings. The method further includes closing the first opening in the housing unit with a plate member. The plate member includes a pressure reduction hole located directly above the intermediate bar while the plate member closes the first opening. In the reducing a pressure in the internal space, the pressure in the internal space is reduced through the pressure reduction hole.

By reducing a pressure in the internal space through the pressure reduction hole directly above the intermediate bar, the pressure can be reduced on both sides of the intermediate bar without imbalance and checking can be done with the same accuracy.

(8) In the method of checking a pressure in a housing unit for a photovoltaic power generation apparatus in (1), the first opening in the housing unit is closed by pressing a plate member against the housing unit with a sealing gasket being interposed before the measuring a pressure in the internal space. The plate member is pressed against the housing unit such that a thickness of the sealing gasket after the plate member is pressed against the housing unit is at least 1/4 and at most 1/2 a thickness of the sealing gasket before the plate member is pressed against the housing unit.

When a thickness of the sealing gasket after the plate member is pressed against the housing unit is larger than 1/2 the thickness of the sealing gasket before the plate member is pressed against the housing unit, sealing by the sealing gasket is insufficient and checking with high accuracy cannot be done. When a thickness of the sealing gasket after the plate member is pressed against the housing unit is smaller than 1/4 the thickness of the sealing gasket before the plate member is pressed against the housing unit, a portion of the housing unit in contact with the sealing gasket may be damaged. In particular when a part of the housing unit is made of an inexpensive resin, there is possibility of damage.

(9) In the method of checking a pressure in a housing unit for a photovoltaic power generation apparatus in (8), the sealing gasket includes a closed-cell structure.

As the sealing gasket thus includes the closed-cell structure, a plurality of pores in the sealing gasket are independent of one another. Pores in the sealing gasket thus do not allow communication from the outside of the housing unit to the internal space. Therefore, leakage through the sealing gasket can reliably be prevented and checking with high accuracy can be done.

### [Details of Embodiment of the Present Disclosure]

### (Construction of Concentrator Photovoltaic Power Generation Apparatus)

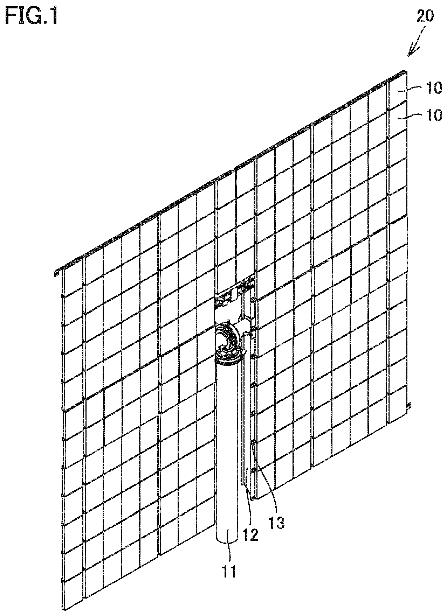

Fig. 1 is a perspective view showing a construction of a concentrator photovoltaic power generation apparatus according to one embodiment. As shown in Fig. 1, a concentrator photovoltaic power generation apparatus 20 includes a plurality of photovoltaic power generation modules 10, a pedestal 11, a plurality of support arms 12, and a plurality of rails 13.

Pedestal 11 is a portion installed on the ground. Pedestal 11 supports the plurality of support arms 12 and the plurality of rails 13. Each of the plurality of support arms 12 is arranged to extend vertically. Each of the plurality of rails 13 is arranged to extend laterally.

The plurality of photovoltaic power generation modules 10 are arranged in matrix on the plurality of rails 13.

The plurality of support arms 12 and the plurality of rails 13 are movable with respect to pedestal 11. For example, positions of the plurality of support arms 12 and the plurality of rails 13 with respect to pedestal 11 are varied such that light receiving surfaces of the plurality of photovoltaic power generation modules 10 face the sun during a period from sunrise to sunset.

### (Construction of Photovoltaic Power Generation Module)

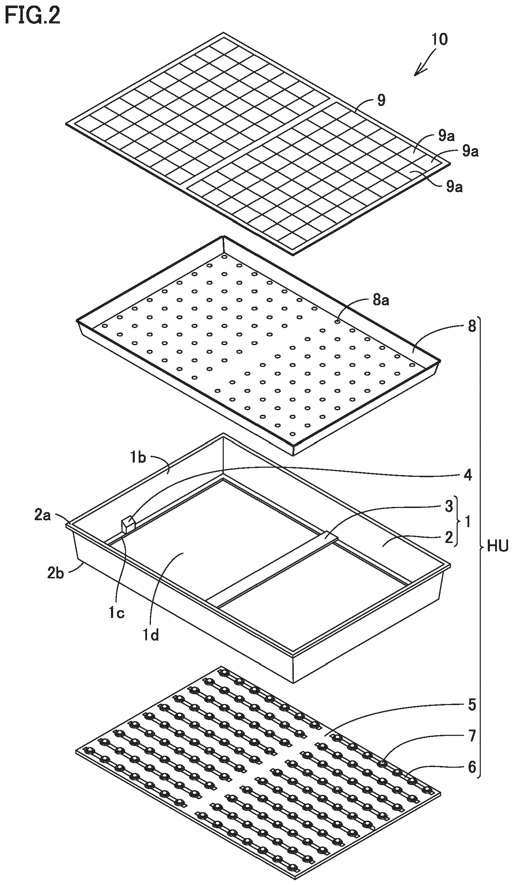

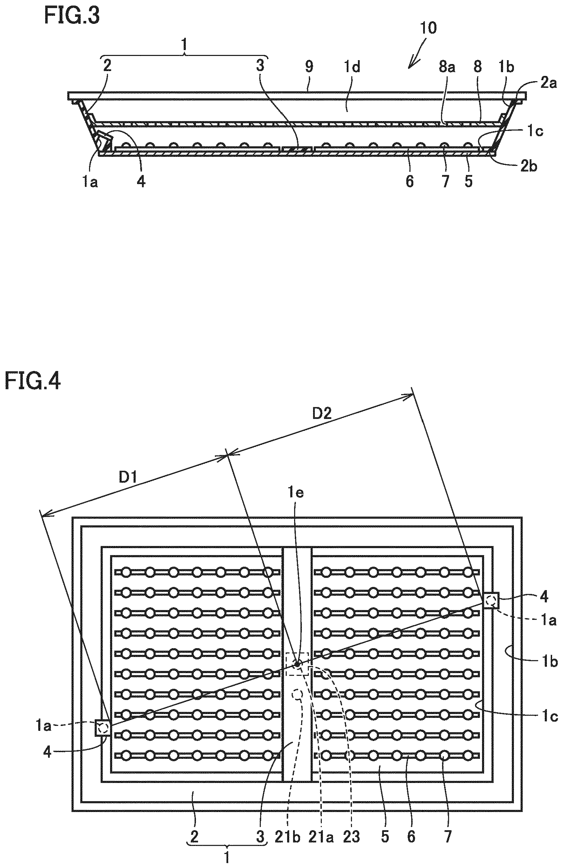

Figs. 2 and 3 are an exploded perspective view and an assembly cross-sectional view showing a construction of the photovoltaic power generation module included in the concentrator photovoltaic power generation apparatus shown in Fig. 1, respectively. Fig. 4 is a plan view showing a construction of a housing unit in which a lens member has been removed from the photovoltaic power generation module shown in Fig. 3.

As shown in Figs. 2 and 3, photovoltaic power generation module 10 mainly includes a housing 1, a porous membrane 4, a bottom plate 5, a plurality of flexible printed circuit boards 6, a plurality of power generation elements 7, a shield plate 8, and a lens member 9.

Housing 1 mainly includes a peripheral wall portion 2 and an intermediate bar 3. Peripheral wall portion 2 is in a frame shape that surrounds an internal space 1d. Peripheral wall portion 2 includes a first end 2a and a second end 2b opposite to first end 2a. Peripheral wall portion 2 includes a first opening 1b at first end 2a and a second opening 1c at second end 2b. Each of first opening 1b and second opening 1c communicates with internal space 1d. Intermediate bar 3 is attached to second end 2b of peripheral wall portion 2 so as to separate second opening 1c into two openings.

A through hole 1a (Fig. 3) is provided in housing 1. Through hole 1a passes through housing 1. Through hole 1a thus allows communication from the outside of housing 1 to internal space 1d. Through hole 1a opens toward second end 2b of peripheral wall portion 2.

Porous membrane 4 is attached to housing 1 to cover the entire through hole 1a. Porous membrane 4 is located within internal space 1d in housing 1. Porous membrane 4 includes a construction like an open-cell structure. Specifically, a plurality of pores in porous membrane 4 communicate with one another and gas can pass between a front surface and a rear surface. Pores in porous membrane 4 thus allow communication from the outside of housing 1 to internal space 1d. Porous membrane 4 is composed, for example, of POREFLON®.

Bottom plate 5 is made from a flat plate, and composed, for example, of a metal material. The plurality of flexible printed circuit boards 6 are carried on a surface of bottom plate 5. The plurality of power generation elements 7 are mounted on the plurality of flexible printed circuit boards 6. Power generation elements 7 are electrically connected to wires of flexible printed circuit boards 6.

Bottom plate 5 is attached to second end 2b of housing 1 by welding. Bottom plate 5 closes second opening 1c in housing 1. While bottom plate 5 is attached to housing 1, the plurality of flexible printed circuit boards 6 and the plurality of power generation elements 7 are located in internal space 1d in housing 1.

Shield plate 8 is made from a flat plate having four edges bent, and composed, for example, of a metal material. Shield plate 8 includes a plurality of light transmission windows (through holes) 8a.

Shield plate 8 is arranged in internal space 1d in housing 1 and attached to housing 1, for example, by a screw (not shown). While shield plate 8 is attached to housing 1, the plurality of light transmission windows 8a are located directly above the plurality of power generation elements 7, respectively. Shield plate 8 performs a function to prevent a portion other than power generation elements 7 from being irradiated with solar rays.

Lens member 9 includes a plurality of lens portions 9a. The plurality of lens portions 9a correspond to the plurality of power generation elements 7, respectively. In other words, solar rays concentrated by a single lens portion 9a are emitted to a single power generation element 7. The plurality of lens portions 9a are arranged in matrix. Each of the plurality of lens portions 9a is, for example, a Fresnel lens.

Lens member 9 is attached to first end 2a of peripheral wall portion 2 by an adhesive. Lens member 9 closes first opening 1b in housing 1. Solar rays concentrated by each of the plurality of lens portions 9a of lens member 9 are emitted to power generation element 7 through each of the plurality of light transmission windows 8a. Each power generation element 7 generates electric power in accordance with an amount of light reception upon receiving solar rays concentrated by corresponding Fresnel lens 9a.

As shown in Fig. 4, housing 1 may be provided with a plurality of through holes 1a. In the present embodiment, for example, two through holes 1a (a first through hole and a second through hole) are provided in housing 1.

One (the first through hole) and the other (the second through hole) of two through holes 1a are arranged such that second opening 1c lies therebetween. Two through holes 1a (the first through hole and the second through hole) are arranged at positions, for example, in point symmetry with respect to a center 1e of housing 1 in a plan view. One (the first through hole) of two through holes 1a is covered with first porous membrane 4 and the other (the second through hole) is covered with second porous membrane 4.

The plan view herein means a point of view in a direction perpendicular to the surface of bottom plate 5.

As shown in Fig. 2, a housing unit HU is constructed by assembling housing 1 to which porous membrane 4 is attached, bottom plate 5 to which flexible printed circuit boards 6 and power generation elements 7 are attached, and shield plate 8.

(Apparatus for Checking Pressure in Housing Unit for Photovoltaic Power Generation Apparatus)

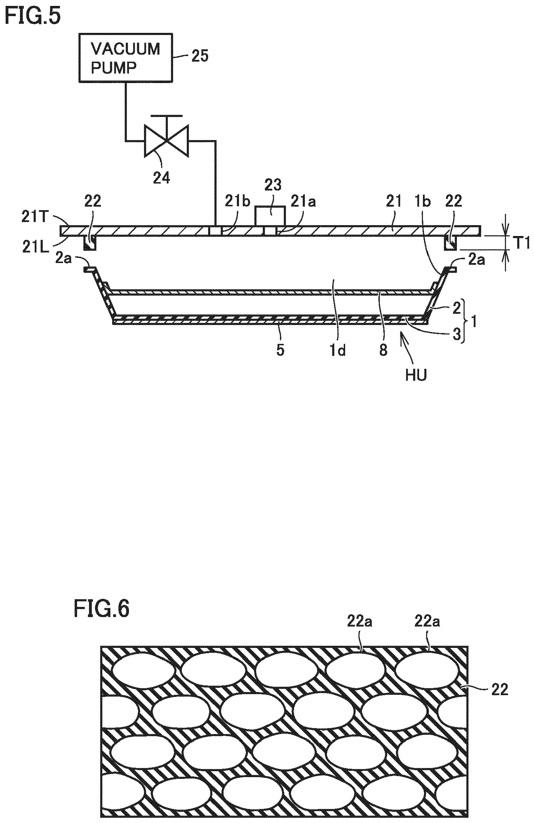

Fig. 5 is a cross-sectional view showing a state before measurement of an internal pressure in the housing unit for the photovoltaic power generation apparatus according to one embodiment. Fig. 6 is a diagram for illustrating a sealing gasket including a closed-cell structure.

As shown in Fig. 5, a pressure in internal space 1d in housing unit HU is checked with a pressure checking apparatus. The pressure checking apparatus mainly includes, for example, a press plate 21 (a plate member), a sealing gasket 22, a pressure sensor 23, a valve 24, and a vacuum pump 25.

Press plate 21 is in a shape of a flat plate. Press plate 21 includes a lower surface 21L located on a side of housing unit HU and an upper surface 21T opposed to lower surface 21L. Press plate 21 includes a through hole 21a and a pressure reduction hole 21b that extend between upper surface 21T and lower surface 21L.

Sealing gasket 22 is attached to lower surface 21L of press plate 21. Sealing gasket 22 is a portion pressed against first end 2a of peripheral wall portion 2 in housing unit HU during checking of a pressure in housing unit HU. Therefore, sealing gasket 22 is arranged in a frame shape for superimposition at least on first end 2a of peripheral wall portion 2 in the plan view.

As shown in Fig. 6, sealing gasket 22 is made, for example, of a foam including a closed-cell structure. Specifically, each of a plurality of voids 22a (pores) in sealing gasket 22 are disposed independently of one another. Therefore, gas cannot pass through sealing gasket 22 through voids in sealing gasket 22. Sealing gasket 22 is made, for example, of a soft foam low in density mainly composed of ethylene propylene diene monomer (EPDM) rubber.

As shown in Fig. 5, pressure sensor 23 is arranged directly above through hole 21a. A pressure in internal space 1d can be measured with pressure sensor 23 through through hole 21a.

Vacuum pump 25 is connected to pressure reduction hole 21b with valve 24 being interposed. Vacuum pump 25 can reduce a pressure in the internal space in housing unit HU. By opening and closing valve 24, selection between connection and disconnection between vacuum pump 25 and internal space 1d can be made.

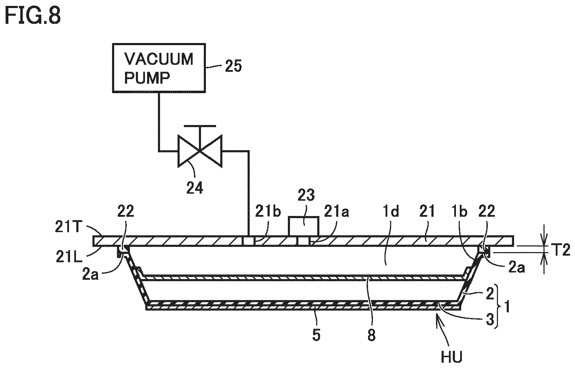

While press plate 21 closes first opening 1b in housing unit HU (Fig. 8), through hole 21a is arranged at a position superimposed on center 1e of housing unit HU in the plan view as shown in Fig. 4. Through hole 21a is arranged directly above intermediate bar 3. Through hole 21a is arranged at a position intermediate between two through holes 1a. Pressure reduction hole 21b is arranged directly above intermediate bar 3.

Through hole 21a being arranged at a position intermediate between two through holes 1a means that through hole 21a is located on a straight line that connects two through holes 1a (the first through hole and the second through hole) to each other in the plan view and a distance D1 between one (the first through hole) of two through holes 1a and through hole 21a is equal to a distance D2 between the other (the second through hole) of two through holes 1a and through hole 21a.

Pressure sensor 23 is arranged to be located at center 1e of housing unit HU in the plan view while press plate 21 closes first opening 1b of housing unit HU. Pressure sensor 23 is arranged directly above intermediate bar 3. Pressure sensor 23 is arranged at a position intermediate between two through holes 1a.

Pressure sensor 23 being arranged at a position intermediate between two through holes 1a means that pressure sensor 23 is located on a straight line that connects two through holes 1a (the first through hole and the second through hole) to each other in the plan view and a distance between one (the first through hole) of two through holes 1a and pressure sensor 23 is equal to a distance between the other (the second through hole) of two through holes 1a and pressure sensor 23.

### (Method of Checking Pressure in Housing Unit for Photovoltaic Power Generation Apparatus)

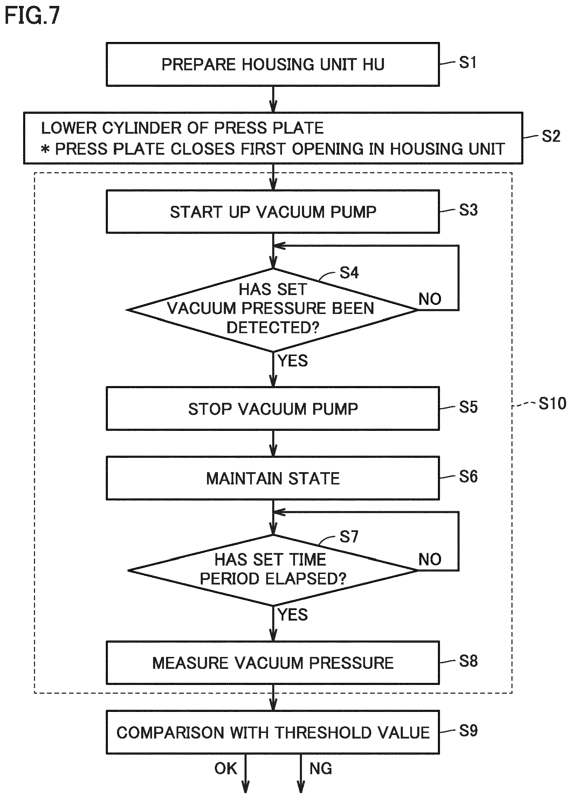

Fig. 7 is a flowchart showing a method of checking a pressure in the housing unit for the photovoltaic power generation apparatus according to one embodiment. Fig. 8 is a cross-sectional view showing a state of measurement of an internal pressure in the housing unit for the photovoltaic power generation apparatus according to one embodiment.

As shown in Figs. 5 and 7, in the method of checking a pressure in the present embodiment, housing unit HU is initially prepared (step S1: Fig. 7). Housing unit HU is prepared to include first opening 1b, internal space 1d in communication with first opening 1b, through hole 1a (the first through hole: Figs. 3 and 4) that allows communication from the outside to internal space 1d, and porous membrane 4 (the first porous membrane: Figs. 3 and 4) that covers through hole 1a. Specifically, housing unit HU is prepared by assembling housing 1 to which porous membrane 4 is attached as described above, bottom plate 5 to which flexible printed circuit boards 6 and power generation elements 7 are attached, and shield plate 8.

Thereafter, a cylinder attached to press plate 21 operates. Press plate 21 is thus lowered toward housing unit HU (step S2: Fig. 7).

As shown in Figs. 7 and 8, press plate 21 is lowered until sealing gasket 22 comes in intimate contact with first end 2a of peripheral wall portion 2 in housing unit HU. Press plate 21 is thus pressed against housing unit HU with sealing gasket 22 being interposed to close first opening 1b in housing unit HU (step S2: Fig. 7).

At this time, press plate 21 is preferably pressed against housing unit HU such that a thickness T2 (Fig. 8) of sealing gasket 22 after press plate 21 is pressed against housing unit HU is at least 1/4 and at most 1/2 a thickness T1 (Fig. 5) of sealing gasket 22 before press plate 21 is pressed against housing unit HU.

Thereafter, while press plate 21 closes first opening 1b in housing unit HU, vacuum pump 25 is started up (step S3: Fig. 7). Valve 24 is open at this time. As vacuum pump 25 is started up, a pressure in internal space 1d in housing unit HU is reduced. The pressure in internal space 1d is reduced by exhausting gas in internal space 1d by vacuum pump 25 through pressure reduction hole 21b located directly above intermediate bar 3.

Whether or not the pressure in internal space 1d after pressure reduction has attained to a set pressure is detected (step S4: Fig. 7). When the pressure in internal space 1d after pressure reduction has not attained to the set pressure, reduction in pressure in internal space 1d is continued until the pressure reaches the set pressure. The set pressure is, for example, not lower than -2500 Pa and not higher than -800 Pa.

When the pressure in internal space 1d after pressure reduction has attained to the set pressure, an operation of vacuum pump 25 is stopped (step S5: Fig. 7). Reduction in pressure in internal space 1d is thus stopped.

Thereafter, a state that reduction in pressure in internal space 1d has been stopped is maintained (step S6: Fig. 7). At this time, the pressure in internal space 1d is negative with respect to the outside. Therefore, when the state that reduction in pressure in internal space 1d has been stopped is maintained, air flows in from the outside of housing unit HU into internal space 1d through pores in porous membrane 4. The negative pressure in internal space 1d thus gradually becomes weaker.

If a gap or a hole is produced between bottom plate 5 and housing 1 or between porous membrane 4 and housing 1, a rate of negative pressure weakening in internal space 1d is higher than in an example where no gap or hole is present. Namely, a rate of flow of air into internal space 1d is higher. Therefore, by measuring a pressure in internal space 1d, whether or not a gap or a hole is present between bottom plate 5 and housing 1 or between porous membrane 4 and housing 1 can be sensed.

Whether or not a set time period has elapsed since stop of reduction in pressure in internal space 1d is sensed (step S7: Fig. 7) and the pressure in internal space 1d at the time point of lapse of the set time period is measured (step S8: Fig. 7).

After the pressure in internal space 1d in housing unit HU is thus reduced and that state is maintained for the set time period, the pressure in internal space 1d is measured. The pressure in internal space 1d is measured with pressure sensor 23. Specifically, the pressure in internal space 1d is measured with pressure sensor 23 arranged directly above intermediate bar 3. As shown in Fig. 4, the pressure in internal space 1d is measured with pressure sensor 23 arranged at a position intermediate between two through holes 1a.

The measured pressure in internal space 1d is compared with a threshold value (step S9: Fig. 7). By comparing the measured pressure in internal space 1d with the threshold value, whether or not a gap or a hole is present in housing unit HU other than the plurality of pores in porous membrane 4 can be determined. Specifically, whether or not a gap or a hole is present between porous membrane 4 and housing 1 or between bottom plate 5 and housing 1 can be determined.

In step S10 including step S3 to step S8 in Fig. 7, measurement of the pressure in internal space 1d in housing unit HU by pressure sensor 23 may continuously be conducted.

### (Result of Check of Pressure in Housing Unit for Photovoltaic Power Generation Apparatus)

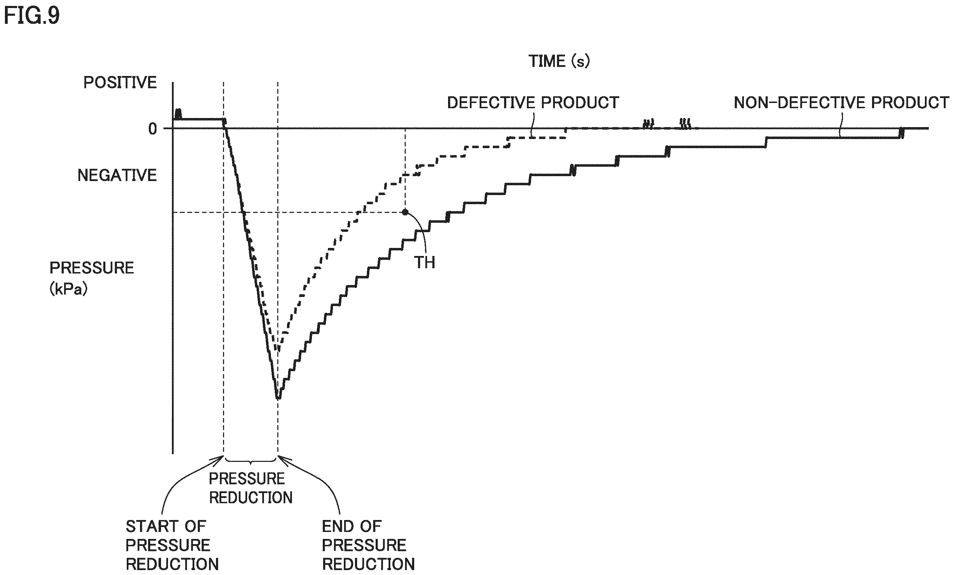

The present inventors inspected change in pressure in internal space 1d when the pressure in internal space 1d was reduced in the pressure checking method. Fig. 9 shows results.

As shown in Fig. 9, as reduction in pressure in internal space 1d was started, the pressure in internal space 1d increased toward a negative pressure side (a minus side). The pressure in internal space 1d was maximum on the negative pressure side at the time point of end of pressure reduction. At this time, the negative pressure in internal space 1d at the time point of end of pressure reduction was weaker in a defective product than in a non-defective product. This may be because an unintended gap or hole was produced in housing unit HU in the defective product and hence outside air was introduced into internal space 1d through this gap or hole during pressure reduction and the negative pressure did not become strong.

When housing unit HU was left stand in a state of pressure check after end of reduction in pressure, the negative pressure in internal space 1d gradually became weaker. At this time, a rate of negative pressure weakening in internal space 1d was higher in the defective product than in the non-defective product. This may be because an unintended gap or hole was produced in housing unit HU in the defective product and hence outside air flowed into internal space 1d at a rate higher than in the non-defective product.

As set forth above, change in pressure is different between the non-defective product and the defective product. Therefore, by setting a prescribed pressure after lapse of a set time period since start of pressure reduction as a threshold value TH, when the pressure in internal space 1d is larger in value on the negative pressure side than threshold value TH, determination as the non-defective product can be made, and when the pressure is smaller in value on the negative pressure side, determination as the defective product can be made.

### (Comparison Between Reduction and Increase in Pressure in Internal Space 1d in Housing Unit HU)

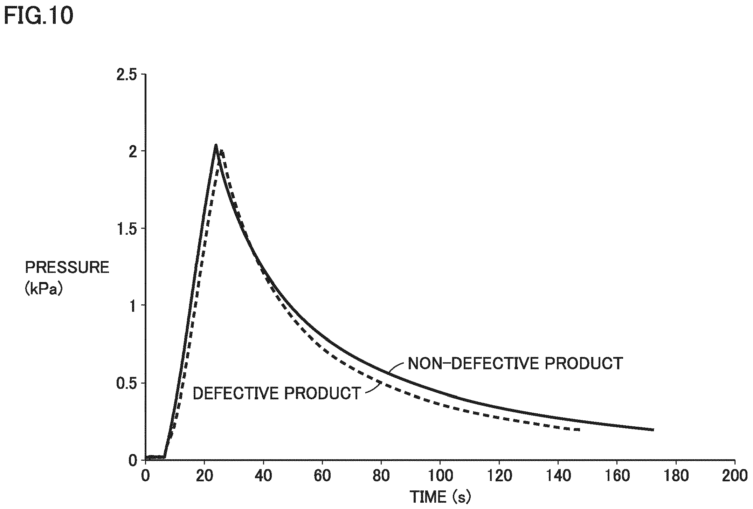

The present inventors inspected change in pressure in internal space 1d when the pressure in internal space 1d was increased instead of being reduced in the pressure checking method. Fig. 10 shows results.

As shown in Fig. 10, when the pressure was increased, no noticeable difference as in pressure reduction (Fig. 9) was observed during change in pressure in each of the non-defective product and the defective product. It was thus found that distinction between the non-defective product and the defective product could accurately be made when the pressure was reduced.

### (Warpage of Housing Unit HU in Reduction in Pressure in Internal Space 1d)

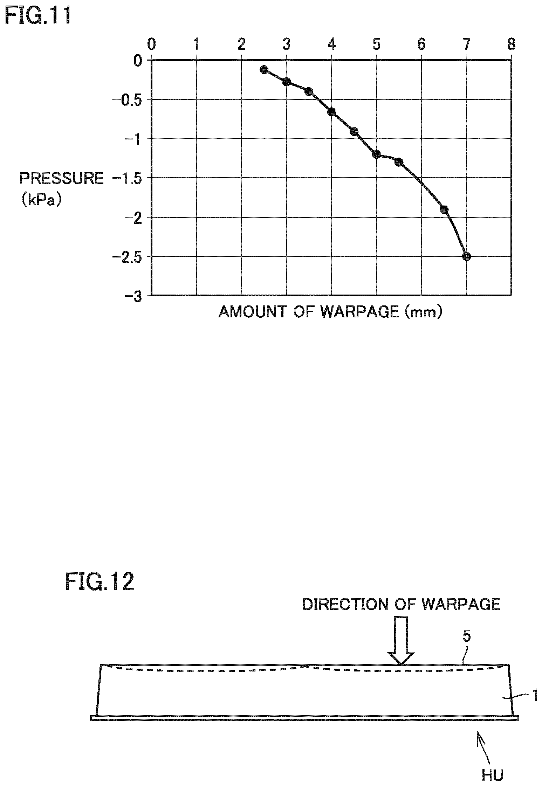

The present inventors inspected an amount of warpage of housing unit HU when the pressure in internal space 1d was reduced in the pressure checking method. Fig. 11 shows results.

The amount of warpage of housing unit HU refers to an amount of warpage of bottom plate 5 of housing unit HU toward internal space 1d as shown in Fig. 12.

As shown in Fig. 11, it was found that, as the pressure during pressure reduction was larger in value toward the negative pressure side, the amount of warpage of housing unit HU was larger. It was also found that, under measurement conditions, when the pressure in internal space 1d exceeded -2500 kPa, the amount of warpage exceeded 7 mm and bottom plate 5 might be damaged.

### (Effect of the Present Embodiment)

In the present embodiment, as shown in Figs. 4 and 8, a pressure in internal space 1d is measured while first opening 1b in housing unit HU including porous membrane 4 is closed. Therefore, change in pressure in internal space 1d in housing unit HU can be measured without immersing housing unit HU in liquid. Therefore, time and trouble and a large space for drying wet housing unit HU are not required. Incorporation (in-line) of this pressure checking process into a line for manufacturing photovoltaic power generation modules 10 is facilitated and checking can be done in a simplified manner and in a short period of time. Time and trouble and efforts for 100% inspection are also less.

By measuring change in pressure, a gap or a hole in housing unit HU other than pores in porous membrane 4 that allows communication from the outside to internal space 1d can be checked for. Whether or not there is a gap or a hole through which rainwater enters housing unit HU in arrangement of photovoltaic power generation module 10 outdoors can thus be determined.

Since determination above is made based on a pressure value or a rate of variation in pressure, accuracy in checking can be high also for housing unit HU in which internal space 1d always communicates with the outside through porous membrane 4.

In the present embodiment, as shown in Figs. 5 and 8, the pressure is checked while housing unit HU is provided with housing 1, porous membrane 4, bottom plate 5, flexible printed circuit boards 6, power generation elements 7, and shield plate 8. By checking the pressure in such a state, checking in a state that photovoltaic power generation module 10 is close to a completed product can be done. Specifically, a gap or a hole that may permit entry of rainwater at a portion where porous membrane 4 is attached to housing 1 and a portion where bottom plate 5 is attached to housing 1 can be checked for.

In the present embodiment, as shown in Fig. 4, the pressure in internal space 1d is measured while pressure sensor 23 is arranged directly above intermediate bar 3. Therefore, checking can be done on both sides of intermediate bar 3 with the same accuracy without any imbalance.

In the present embodiment, as shown in Fig. 4, the pressure in internal space 1d is measured while pressure sensor 23 is arranged at a position intermediate between two through holes 1a. Therefore, pressure sensor 23 is located equidistantly from two porous membranes 4 and hence checking can be done on both sides with the same accuracy without any imbalance.

In the present embodiment, as shown in Fig. 7, the pressure in internal space 1d is measured after the pressure in internal space 1d in housing unit HU is reduced. Thus, as shown in Figs. 9 and 10, checking higher in accuracy than in measurement of the pressure after increase in pressure in internal space 1d can be done. A load test of photovoltaic power generation module 10 is conducted by applying a load onto a rear surface of bottom plate 5 to warp bottom plate 5 toward internal space 1d. By reducing a pressure in internal space 1d, a pseudo load test of photovoltaic power generation module 10 can also be conducted as shown in Fig. 11.

In the present embodiment, the pressure in internal space 1d in housing unit HU is reduced to a pressure not lower than -2500 Pa and not higher than -800 Pa. When the pressure in internal space 1d is higher than -800 Pa (a negative pressure is weaker), a pressure difference between a non-defective product and a defective product is too small and accuracy in checking is poor. Since 800 Pa is one of references defined by the International Electrotechnical Commission (IEC), the pressure in internal space 1d being not higher than -800 Pa (the negative pressure being larger than 800 Pa) is desirable in conducting the pseudo load test of photovoltaic power generation module 10. When the pressure in internal space 1d is lower than -2500 Pa (a negative pressure is stronger), bottom plate 5 may deform and photovoltaic power generation module 10 may be damaged.

In the present embodiment, as shown in Fig. 4, the pressure in internal space 1d is measured while pressure reduction hole 21b is located directly above intermediate bar 3. The pressure can thus be reduced on both sides of intermediate bar 3 without imbalance and checking can be done with the same accuracy on both sides of intermediate bar 3.

In the present embodiment, as shown in Figs. 5 and 8, press plate 21 is pressed against housing unit HU such that thickness T2 (Fig. 8) of sealing gasket 22 after press plate 21 is pressed against housing unit HU is at least 1/4 and at most 1/2 thickness T1 (Fig. 5) of sealing gasket 22 before press plate 22 is pressed against housing unit HU. When thickness T2 is larger than 1/2 thickness T1, sealing by sealing gasket 22 is insufficient and checking with high accuracy cannot be done. When thickness T2 is smaller than 1/4 thickness T1, a portion of housing unit HU in contact with sealing gasket 22 may be damaged. In particular when a part of housing unit HU is made of an inexpensive resin, there is possibility of damage.

Since press plate 21 is pressed against first end 2a of housing 1 with soft sealing gasket 22 low in density being interposed as described above, sealing gasket 22 can provide sufficient sealing even though there are irregularities on the end surface of first end 2a.

In the present embodiment, as shown in Fig. 6, sealing gasket 22 includes the closed-cell structure. A plurality of voids 22a in sealing gasket 22 are thus independent of one another. Voids 22a in sealing gasket 22 thus do not allow communication from the outside of housing unit HU to internal space 1d. Therefore, leakage through sealing gasket 22 can reliably be prevented and checking with high accuracy can be done.

It should be understood that the embodiment disclosed herein is illustrative and non-restrictive in every respect. The scope of the present invention is defined by the terms of the claims rather than the embodiment above and is intended to include any modifications within the scope and meaning equivalent to the terms of the claims.

### REFERENCE SIGNS LIST

1 housing; 1a, 21a through hole; 1b first opening; 1c second opening; 1d internal space; 1e center; 2 peripheral wall portion; 2a first end; 2b second end; 3 intermediate bar; 4 porous membrane; 5 bottom plate; 6 flexible printed circuit board; 7 power generation element; 8 shield plate; 8a light transmission window; 9 lens member; 9a lens portion; 10 photovoltaic power generation module; 11 pedestal; 12 support arm; 13 rail; 20 concentrator photovoltaic power generation apparatus; 21 press plate; 21L lower surface; 21T upper surface; 21b pressure reduction hole; 22 sealing gasket; 22a void; 23 pressure sensor; 24 valve; 25 vacuum pump; HU housing unit

## Claims

1. A method of checking a pressure in a housing unit for a photovoltaic power generation apparatus, the method comprising:
preparing a housing unit, the housing unit including a first opening, an internal space in communication with the first opening, a first through hole that allows communication from outside to the internal space, and a first porous membrane that covers the first through hole and includes pores that allow communication from the outside to the internal space; and
measuring a pressure in the internal space while the first porous membrane covers the first through hole and the first opening in the housing unit is closed.

2. The method of checking a pressure in a housing unit for a photovoltaic power generation apparatus according to claim 1, wherein
in the preparing a housing unit, the housing unit is prepared to include
a housing that surrounds the internal space, the housing including the first opening at a first end and a second opening at a second end opposed to the first end,
a bottom plate attached to the housing to close the second opening,
a flexible printed circuit board attached to the bottom plate to be located in the internal space, on which a power generation element is mounted, and
a shield plate located above the flexible printed circuit board, the shield plate including a light transmission window directly above the power generation element.

3. The method of checking a pressure in a housing unit for a photovoltaic power generation apparatus according to claim 2, wherein
in the preparing a housing unit, the housing is prepared to include
a peripheral wall portion that includes the first opening at the first end and the second opening at the second end, and
an intermediate bar attached to the peripheral wall portion to separate the second opening into two openings, and
in the measuring a pressure in the internal space, a pressure in the internal space is measured with a pressure sensor arranged directly above the intermediate bar.

4. The method of checking a pressure in a housing unit for a photovoltaic power generation apparatus according to claim 2, wherein
in the preparing a housing unit, the housing unit is prepared to include
a second through hole that is arranged such that the second opening lies between the second through hole and the first through hole and allows communication from the outside to the internal space, and
a second porous membrane that covers the second through hole, and
in the measuring a pressure in the internal space, a pressure in the internal space is measured with a pressure sensor arranged at a position intermediate between the first through hole and the second through hole in a plan view.

5. The method of checking a pressure in a housing unit for a photovoltaic power generation apparatus according to claim 2, further comprising reducing a pressure in the internal space in the housing unit before the measuring a pressure in the internal space.

6. The method of checking a pressure in a housing unit for a photovoltaic power generation apparatus according to claim 5, wherein
the pressure in the internal space in the housing unit is reduced to a pressure not lower than -2500 Pa and not higher than -800 Pa.

7. The method of checking a pressure in a housing unit for a photovoltaic power generation apparatus according to claim 5, wherein
in the preparing a housing unit, the housing is prepared to include
a peripheral wall portion that includes the first opening at the first end and the second opening at the second end, and
an intermediate bar attached to the peripheral wall portion to separate the second opening into two openings,
the method further comprises closing the first opening in the housing unit with a plate member,
the plate member includes a pressure reduction hole located directly above the intermediate bar while the plate member closes the first opening, and
in the reducing a pressure in the internal space, the pressure in the internal space is reduced through the pressure reduction hole.

8. The method of checking a pressure in a housing unit for a photovoltaic power generation apparatus according to claim 1, further comprising closing the first opening in the housing unit by pressing a plate member against the housing unit with a sealing gasket being interposed before the measuring a pressure in the internal space, wherein
the plate member is pressed against the housing unit such that a thickness of the sealing gasket after the plate member is pressed against the housing unit is at least 1/4 and at most 1/2 a thickness of the sealing gasket before the plate member is pressed against the housing unit.

9. The method of checking a pressure in a housing unit for a photovoltaic power generation apparatus according to claim 8, wherein
the sealing gasket includes a closed-cell structure.
